# EUROPEAN PATENT APPLICATION

(11) **EP 3 125 657 A1**
(43) Date of publication of application: **01.02.2017**
(21) Application number: 14886758.3
(22) Date of filing: 14.08.2014
(51) Int. Cl.: H05K 7/20

(54) **LIQUID-COOLING HEAT DISSIPATION SERVER**

(30) Priority: 28.03.2014 CN 201420149497 U
(71) Applicant: ZTE Corporation, Shenzhen, Guangdong 518057 (CN)
(72) Inventor: XU, Yongtian, Shenzhen Guangdong 518057 (CN); SONG, Xiaojun, Shenzhen Guangdong 518057 (CN)
(74) Representative: Novagraaf Technologies
(86) International application number: PCT/CN2014/084434
(87) International publication number: WO 2015/143819

(57) **Abstract**

Provided is a liquid-cooling heat dissipation server, and the server includes a cabinet (10), at least one board (20) that is arranged in the cabinet (10), and a liquid separation channel and a liquid collection channel that are arranged at two sides of the cabinet (10) oppositely, wherein a liquid inlet of each board (20) is intercommunicated with the liquid separation channel through a first plug-type quick connector (30) and a liquid outlet of each board (20) is intercommunicated with the liquid collection channel through a second plug-type quick connector (40). According to the liquid-cooling heat dissipation serer in the present disclosure, the board (20) is directly intercommunicated with the liquid separation channel and the liquid collection channel through the first plug-type quick connector (30) and the second plug-type quick connector (40), so that a communicating pipeline is eliminated, the structure of the liquid-cooling heat dissipation server is simplified, the board (20) can be mounted and demounted in an easy plug mode, and the liquid-cooling heat dissipation server is very convenient and practical.

## Description

### Technical Field

The present disclosure relates to the field of heat dissipation and cooling technologies, and in particular to a liquid-cooling heat dissipation server.

### Background

In servers applied to electronic industry, communication industry and other industries, electronic chips and power devices are first assembled on modules (boards) which then are assembled in a cabinet of a server. As the heat consumption of electronic chips and power devices becomes larger and larger, some servers have to adopt a liquid-cooling method to dissipate heat.

In existing liquid-cooling heat dissipation servers, a liquid cooling system generally supplies a liquid to each board through a liquid separation pipeline and then recovers, through a liquid collection pipeline, the liquid flowing from each board after heat exchange. Generally, each board is connected to the liquid separation pipeline and the liquid collection pipeline through a pipeline, thus the board is inconvenient to mount and demount and has a complex structure.

### Summary

The main purpose of the present disclosure is to provide a liquid-cooling heat dissipation server which has a simple structure and whose board is convenient to mount and demount.

The present disclosure provides a liquid-cooling heat dissipation server, including a cabinet, at least one board that is arranged in the cabinet, and a liquid separation channel and a liquid collection channel that are arranged at two sides of the cabinet oppositely, wherein a liquid inlet of each board is intercommunicated with the liquid separation channel through a first plug-type quick connector, a first end of each first plug-type quick connector is intercommunicated and fixed with the liquid separation channel while a second end of each first plug-type quick connector is docked and fixed with the liquid inlet of a corresponding board; and
a liquid outlet of each board is intercommunicated with the liquid collection channel through a second plug-type quick connector, a first end of each second plug-type quick connector is intercommunicated and fixed with the liquid collection channel while a second end of each second plug-type quick connector is docked and fixed with the liquid outlet of a corresponding board.

Preferably, the cabinet includes a first side plate in which the liquid separation channel is arranged and a second side plate in which the liquid collection channel is arranged that are oppositely arranged.

Preferably, the first end of each first plug-type quick connector is fixed on an end face of the first side plate far away from a back plate of the cabinet, and the first end of each second plug-type quick connector is fixed on an end face of the second side plate far away from the back plate of the cabinet;
one end of each board far away from the back plate extends out a first extension part towards the direction of the first side plate and a second extension part towards the direction of the second side plate respectively, the liquid inlet of each board is arranged on the first extension part while the liquid outlet of each board is arranged on the second extension part.

Preferably, the first end of each first plug-type quick connector is a female connector of the first plug-type quick connector while the second end of each first plug-type quick connector is a male connector of the first plug-type quick connector; and the first end of each second plug-type quick connector is a female connector of the second plug-type quick connector while the second end of each second plug-type quick connector is a male connector of the second plug-type quick connector.

Preferably, an air outlet is arranged on the back plate of the cabinet, and a fan is installed in the cabinet corresponding to the position of the air outlet.

Preferably, a liquid-cooling system of which a liquid supply pipe is tightly connected to the liquid separation channel and of which a liquid return pipe is tightly connected to the liquid collection channel is further arranged in the cabinet.

Preferably, a plurality of ventilation holes is arranged on the back plate of the cabinet corresponding to the liquid-cooling system.

In the liquid-cooling heat dissipation serer provided in the present disclosure, the board is directly intercommunicated with the liquid separation channel and the liquid collection channel through the first plug-type quick connector and the second plug-type quick connector, so that a communicating pipeline is eliminated and the structure of the liquid-cooling heat dissipation server is simplified. When it is needed to demount a board, it is only needed to pull out and disconnect the two ends of the first plug-type quick connector and the second plug-type quick connector and to automatically seal the liquid inlet and liquid outlet of the board and meanwhile seal the liquid separation channel and liquid collection channel; when it is needed to mount a board, it is only needed to insert and intercommunicate the two ends of the first plug-type quick connector and the second plug-type quick connector correspondingly. The board can be mounted and demounted in an easy plug mode, and the liquid-cooling heat dissipation server is very convenient and practical.

### Brief Description of the Drawings

Fig. 1 is a structure diagram of a first angle of view of a preferred embodiment of a liquid-cooling heat dissipation server according to an embodiment of the present disclosure; and
Fig. 2 is a structure diagram of a second angle of view of a preferred embodiment of a liquid-cooling heat dissipation server according to an embodiment of the present disclosure.

The purpose implementation, the function features and the advantages of the present disclosure are described below in further detail in conjunction with embodiments by reference to accompanying drawings.

### Detailed Description of the Embodiments

It should be understood that specific embodiments described below are simply to illustrate the present disclosure but to limit the present disclosure.

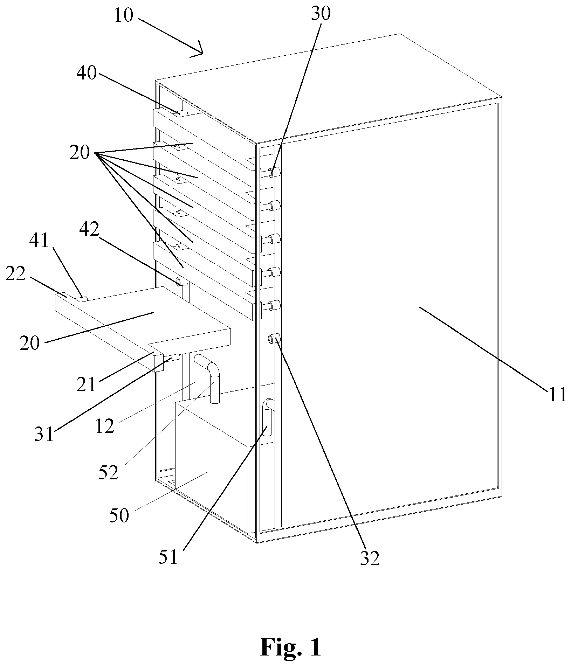

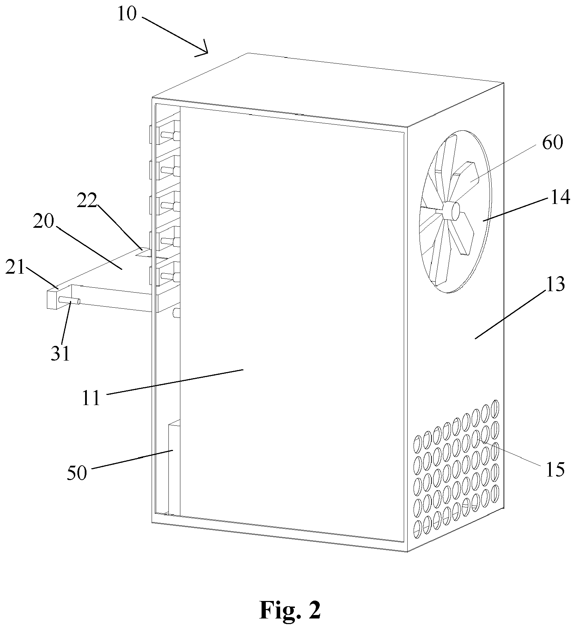

As shown in Fig. 1 and Fig. 2, Fig. 1 is a structure diagram of a first angle of view of a preferred embodiment of a liquid-cooling heat dissipation server according to the present disclosure, and Fig. 2 is a structure diagram of a second angle of view of a preferred embodiment of a liquid-cooling heat dissipation server according to the present disclosure.

Refer to Fig. 1 and Fig. 2, a liquid-cooling heat dissipation server provided in this embodiment includes a cabinet 10, at least one board 20 that is arranged in the cabinet, and a liquid separation channel (not shown) and a liquid collection channel (not shown) that are arranged at two sides of the cabinet 10 oppositely, wherein a liquid inlet of each board 20 is intercommunicated with the liquid separation channel through a first plug-type quick connector 30, a first end 31 of each first plug-type quick connector 30 is intercommunicated and fixed with the liquid separation channel while a second end 32 of each first plug-type quick connector 30 is docked and fixed with the liquid inlet of a corresponding board 20; and a liquid outlet of each board 20 is intercommunicated with the liquid collection channel through a second plug-type quick connector 40, a first end 41 of each second plug-type quick connector 40 is intercommunicated and fixed with the liquid collection channel while a second end 42 of each second plug-type quick connector 40 is docked and fixed with the liquid outlet of a corresponding board 20. The two ends of the plug-type quick connector are intercommunicated or disconnected through plug; in particular, the two ends are intercommunicated when inserted into the channels; and the two ends are sealed respectively when disconnected with the channels. When the liquid-cooling heat dissipation server is used, the connection between the liquid separation channel, the liquid collection channel and a liquid-cooling device (external or embedded) forms a re-circulated liquid-cooling heat dissipation circuit.

In the liquid-cooling heat dissipation server provided in this embodiment, the board 20 is directly intercommunicated with the liquid separation channel and the liquid collection channel through the first plug-type quick connector 30 and the second plug-type quick connector 40, so that a communicating pipeline is eliminated and the structure of the liquid-cooling heat dissipation server is simplified. When it is needed to demount a board 20, it is only needed to pull out and disconnect the two ends of the first plug-type quick connector 30 and the second plug-type quick connector 40 and to automatically seal the liquid inlet and liquid outlet of the board 20 and meanwhile seal the liquid separation channel and liquid collection channel; when it is needed to mount a board 20, it is only needed to insert and intercommunicate the two ends of the first plug-type quick connector 30 and the second plug-type quick connector 40 correspondingly. The board 20 can be mounted and demounted in an easy plug mode, and the liquid-cooling heat dissipation server is very convenient and practical.

Further, the cabinet 10 includes a first side plate 11 in which the liquid separation channel is arranged and a second side plate 12 in which the liquid collection channel is arranged that are oppositely arranged. As the liquid separation channel and the liquid collection channel are integrated into the two side plates of the cabinet 10 respectively, the pipeline inside the cabinet 10 is further simplified and the space utilization ratio of the cabinet 10 is improved.

In particular, in this embodiment, the first end 31 of each first plug-type quick connector 30 is fixed on an end face of the first side plate 11 far away from a back plate 13 of the cabinet 10, and the first end 41 of each second plug-type quick connector 40 is fixed on an end face of the second side plate 12 far away from the back plate 13 of the cabinet 10; one end of each board 20 far away from the back plate 13 extends out a first extension part 21 towards the direction of the first side plate 11 and a second extension part 22 towards the direction of the second side plate 12 respectively, the liquid inlet of each board 20 is arranged on the first extension part 21 while the liquid outlet of each board 20 is arranged on the second extension part 22. When the board 20 is mounted and demounted, the insertion or pull-out operations may be directly carried out in the front side (one side opposite the back plate 13) of the cabinet 10, which are more convenient.

In particular, in this embodiment, the first end 31 of each first plug-type quick connector 30 is a female connector of the first plug-type quick connector 30 while the second end 32 of each first plug-type quick connector 30 is a male connector of the first plug-type quick connector 30; and the first end 41 of each second plug-type quick connector 40 is a female connector of the second plug-type quick connector 40 while the second end 42 of each second plug-type quick connector 40 is a male connector of the second plug-type quick connector 40. Of course, this embodiment just takes the above as an example, it also may be the first end 31 of the first plug-type quick connector 30 is a male connector while the second end 32 is a female connector, the first end 41 of the second plug-type quick connector 40 is a male connector while the second end 42 is a female connector.

Further, since some parts in the liquid-cooling heat dissipation cabinet 10 are not liquid cooled, in this embodiment an air outlet 14 is arranged on the back plate 13 of the cabinet 10, and a fan 60 is installed in the cabinet 10 corresponding to the position of the air outlet 14, for air-cooling the non-liquid cooled parts in the cabinet 10.

Further, in this embodiment a liquid-cooling system 50 of which a liquid supply pipe 51 is tightly connected to the liquid separation channel and of which a liquid return pipe 52 is tightly connected to the liquid collection channel is further arranged in the cabinet 10. The liquid-cooling heat dissipation server contains the liquid-cooling system 50 to form an independent heat dissipation system, without connecting to an external liquid-cooling device through a pipeline, such that the liquid-cooling heat dissipation server is not limited by the pipeline, may be used in a mobile manner and is more flexible for indoor and outdoor use.

A plurality of ventilation holes 15 is arranged on the back plate 13 of the cabinet 10 corresponding to the liquid-cooling system 50, ensuring a good ventilation effect of the cabinet 10 and dissipating out the heat inside the cabinet 10 more quickly.

The above are merely the preferred embodiments of the present disclosure and are not intended to limit the patent scope of the present disclosure. Any equivalent structures or equivalent flow modifications made according to the description and the accompanying drawings of the present disclosure, or any equivalent structures or equivalent flow modifications applied in other relevant technical fields directly or indirectly are intended to be included in the patent protection scope of the present disclosure.

### Industrial Applicability

In the liquid-cooling heat dissipation serer provided in the present disclosure, the board is directly intercommunicated with the liquid separation channel and the liquid collection channel through the first plug-type quick connector and the second plug-type quick connector, so that a communicating pipeline is eliminated and the structure of the liquid-cooling heat dissipation server is simplified. When it is needed to demount a board, it is only needed to pull out and disconnect the two ends of the first plug-type quick connector and the second plug-type quick connector and to automatically seal the liquid inlet and liquid outlet of the board and meanwhile seal the liquid separation channel and liquid collection channel; when it is needed to mount a board, it is only needed to insert and intercommunicate the two ends of the first plug-type quick connector and the second plug-type quick connector correspondingly. The board can be mounted and demounted in an easy plug mode, and the liquid-cooling heat dissipation server is very convenient and practical.

## Claims

1. A liquid-cooling heat dissipation server, comprising a cabinet, at least one board that is arranged in the cabinet, and a liquid separation channel and a liquid collection channel that are arranged at two sides of the cabinet oppositely, wherein a liquid inlet of each board is intercommunicated with the liquid separation channel through a first plug-type quick connector, a first end of each first plug-type quick connector is intercommunicated and fixed with the liquid separation channel while a second end of each first plug-type quick connector is docked and fixed with the liquid inlet of a corresponding board; and
a liquid outlet of each board is intercommunicated with the liquid collection channel through a second plug-type quick connector, a first end of each second plug-type quick connector is intercommunicated and fixed with the liquid collection channel while a second end of each second plug-type quick connector is docked and fixed with the liquid outlet of a corresponding board.

2. The liquid-cooling heat dissipation server according to claim 1, wherein the cabinet comprises a first side plate in which the liquid separation channel is arranged and a second side plate in which the liquid collection channel is arranged that are oppositely arranged.

3. The liquid-cooling heat dissipation server according to claim 2, wherein the first end of each first plug-type quick connector is fixed on an end face of the first side plate far away from a back plate of the cabinet, and the first end of each second plug-type quick connector is fixed on an end face of the second side plate far away from the back plate of the cabinet;
one end of each board far away from the back plate extends out a first extension part towards the direction of the first side plate and a second extension part towards the direction of the second side plate respectively, the liquid inlet of each board is arranged on the first extension part while the liquid outlet of each board is arranged on the second extension part.

4. The liquid-cooling heat dissipation server according to claim 3, wherein the first end of each first plug-type quick connector is a negative connector of the first plug-type quick connector while the second end of each first plug-type quick connector is a positive connector of the first plug-type quick connector; and the first end of each second plug-type quick connector is a negative connector of the second plug-type quick connector while the second end of each second plug-type quick connector is a positive connector of the second plug-type quick connector.

5. The liquid-cooling heat dissipation server according to claim 1, wherein an air outlet is arranged on the back plate of the cabinet, and a fan is installed in the cabinet corresponding to the position of the air outlet.

6. The liquid-cooling heat dissipation server according to any one of claims 1 to 5, wherein a liquid-cooling source of which a liquid supply pipe is tightly connected to the liquid separation channel and of which a liquid return pipe is tightly connected to the liquid collection channel is further arranged in the cabinet.

7. The liquid-cooling heat dissipation server according to claim 6, wherein a plurality of ventilation holes is arranged on the back plate of the cabinet corresponding to the liquid-cooling source.
